# EUROPÄISCHE PATENTSCHRIFT

(11) **EP 1 347 937 B1**
(45) Veröffentlichungstag und Bekanntmachung des Hinweises auf die Patenterteilung: **03.05.2006**
(21) Anmeldenummer: 01990295.6
(22) Anmeldetag: 13.12.2001
(51) Int. Cl.: B81B 3/00, B81C 1/00

(54) **MIKROMECHANISCHES BAUELEMENT UND ENTSPRECHENDES HERSTELLUNGSVERFAHREN**
MICROMECHANICAL COMPONENT AND CORRESPONDING PRODUCTION METHOD
COMPOSANT MICROMECANIQUE ET PROCEDE DE PRODUCTION CORRESPONDANT

(30) Priorität: 23.12.2000 DE 10065026
(43) Veröffentlichungstag der Anmeldung: 01.10.2003
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nuertingen (DE); ARTMANN, Hans, 71106 Magstadt (DE); SCHAEFER, Frank, 72070 Tuebingen (DE)
(86) Internationale Anmeldenummer: PCT/DE2001/004692
(87) Internationale Veröffentlichungsnummer: WO 2002/051742

(56) Entgegenhaltungen:
- WO-A-99/45583
- DE-A- 19 754 513
- US-A- 6 004 450
- FRENCH P J ET AL: "Epi-micromachining" MICROELECTRONICS JOURNAL, MACKINTOSH PUBLICATIONS LTD. LUTON, GB, Bd. 28, Nr. 4, 1. Mai 1997 (1997-05-01), Seiten 449-464, XP004061685 ISSN: 0026-2692
- LAMMEL G ET AL: "Free-standing, mobile 3D porous silicon microstructures" SENSORS AND ACTUATORS A, ELSEVIER SEQUOIA S.A., LAUSANNE, CH, Bd. 85, Nr. 1-3, 25. August 2000 (2000-08-25), Seiten 356-360, XP004214496 ISSN: 0924-4247

## Beschreibung

### STAND DER TECHNIK

Die vorliegende Erfindung betrifft ein mikromechanisches Bauelement sowie ein entsprechendes Herstellungsverfahren.

Membranen werden meist in Bulk- oder in Oberflächenmikromechanik hergestellt. Bulkmikromechanische Ausführungen haben den Nachteil, dass sie relativ aufwendig herzustellen und damit teuer sind. Oberflächenmikromechanische Varianten haben den Nachteil, dass im Allgemeinen keine einkristallinen Membranen herstellbar sind.

Einkristalline Membranen sind von Vorteil, da die mechanischen Eigenschaften definierter sind als bei polykristallinen Membranen. Außerdem können in einkristallinen Membranen piezoresistive Widerstände mit einer deutlich besseren Langzeitstabilität und höheren Piezokoeffizienten verglichen mit piezoresistiven Widerständen in polykristallinen Membranen hergestellt werden.

Aus der Druckschrift DE 197 54 513 A1 ist eine Kappenstruktur aus einem ganzen Wafer bekannt, in welchem lokal porös Bereiche geätzt wird. Anschließend wird die Kappenstruktur mit dem porösen Bereich mit einem Mikrosystem durch Bonden, Kleben oder Löten verbunden. Um einen in der Kappenstruktur enthaltenen Bereich vor dem Eindringen von Partikeln zu schützen, weisst das Mikrosystem eine Membran auf.

### VORTEILE DER ERFINDUNG

Das erfindungsgemäße mikromechanische Bauelement mit den Merkmalen des Anspruchs 1 und das entsprechende Herstellungsverfahren nach Anspruch 6 weisen den Vorteil auf, daß sie eine einfache und kostengünstige Herstellung einer Kaverne mit einer darüberliegenden einkristallinen Membran in Oberflächenmikromechanik ermöglichen. Die einkristalline Membran kann beispielsweise für Drucksensoren eingesetzt werden.

Die der vorliegenden Erfindung zugrundeliegende Idee besteht darin, daß zur Herstellung der Membran zunächst ein selektives Anodisieren (porös Ätzen) von n⁺- bzw. p⁺⁻Dotierungsbereichen vorgenommen wird, die lokal durch eine einkristalline Deckschicht, z.B. eine Epitaxieschicht, durchgeführt sind. Es folgt dann ein zeitgesteuerter Wechsel auf eine selektive Elektropolitur einer unter der Membran vergrabenen n⁺- bzw. p⁺-dotierten Schicht. Dadurch wird ein Hohlraum bzw. eine Kaverne unter der Deckschicht erzeugt. Falls nötig, erfolgt letztlich ein Verschließen der porösen n⁺- bzw. p⁺-Dotierungsbereiche in der Deckschicht, um einen definierten Gasdruck in der erzeugten Kaverne einzuschließen.

Weitere Vorteile sind eine einfache Integration in einen Halbleiterschaltungsprozess, und dadurch wird beispielsweise eine Integration einer Membran mit Auswerteschaltung auf einem Chip (z.B. als Drucksensor) möglich. Es treten geringe Unterätzungsschwankungen auf, d.h. genau vorgebbare Abmessungen sind realisierbar. Zudem ist, falls erwünscht, ein einfaches Verschließen der Zugangsöffnungen möglich.

In den Unteransprüchen finden sich vorteilhafte Weiterbildungen und Verbesserungen des jeweiligen Gegenstandes der Erfindung.

Gemäß einer bevorzugten Weiterbildung wird bzw. werden oberhalb der einkristallinen Schicht eine oder mehrere Verschlußschichten zum Verschließen der porösen Bereiche vorgesehen.

Gemäß einer weiteren bevorzugten Weiterbildung werden die porösen Bereiche durch eine Oxidation verschlossen. Dies ist eine besonders effektive Verschlußmethode.

Gemäß einer weiteren bevorzugten Weiterbildung sind die einkristalline Schicht und die porösen Bereiche vom selben Dotierungstyp.

Gemäß einer weiteren bevorzugten Weiterbildung sind die einkristalline Schicht und die porösen Bereiche von verschiedenen Dotierungstypen.

Gemäß einer weiteren bevorzugten Weiterbildung wird die einkristalline Schicht durch Epitaxie vorgesehen.

Gemäß einer weiteren bevorzugten Weiterbildung ist das Substrat von einem ersten Leitungstyp und die vergrabene Schicht von einem zweiten Leitungstyp. In der vergrabenen Schicht werden ein oder mehrere Bereiche des ersten Leitungstyps vorgesehen, die eine im Vergleich zum Substrat erhöhte Dotierung aufweisen. So lassen sich die Stromlinien beim Elektropolieren konzentrieren und unerwünschte Rückstände im Hohlraum vermeiden.

### ZEICHNUNGEN

Ausführungsbeispiele der Erfindung sind in der Zeichnung dargestellt und in der nachfolgenden Beschreibung näher erläutert.

Es zeigen:
- Fig. 1a-c: eine schematische Querschnittsdarstellung des Herstellungsprozesses für ein mikromechanisches Bauelement gemäß einer ersten Ausführungsform der vorliegenden Erfindung;
- Fig. 2a,b: eine schematische Querschnittsdarstellung des Herstellungsprozesses für ein mikromechanisches Bauelement gemäß einer zweiten Ausführungsform der vorliegenden Erfindung;
- Fig. 3: eine mögliche Komplikation bei der Herstellung des erfindungsgemäßen mikromechanischen Bauelements; und
- Fig. 4a,b: eine schematische Querschnittsdarstellung des Herstellungsprozesses für ein mikromechanisches Bauelement gemäß einer dritten Ausführungsform der vorliegenden Erfindung.

### BESCHREIBUNG DER AUSFÜHRUNGSBEISPIELE

In den Figuren bezeichnen gleiche Bezugszeichen gleiche oder funktionsgleiche Bestandteile.

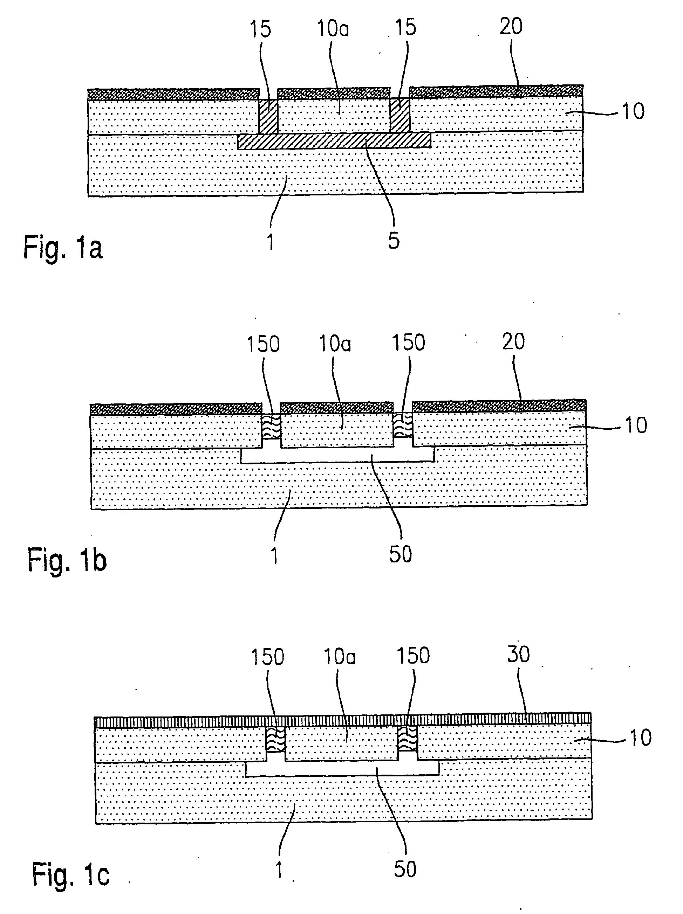

Fig. 1a-c zeigen eine schematische Querschnittsdarstellung des Herstellungsprozesses für ein mikromechanisches Bauelement gemäß einer ersten Ausführungsform der vorliegenden Erfindung.

In Fig. 1a-c bezeichnet Bezugszeichen 1 ein p-dotiertes Siliziumsubstrat, 5 eine vergrabene n⁺-dotierte Schicht, 10 eine n-Epitaxieschicht, 15 n⁺-dotierte Bereiche in der n-Epitaxieschicht 10, 10a einen späteren Membranbereich sowie 20 eine Maske und 30 eine Verschlussschicht z.B. aus Metall, Oxid, Nitrid, BPSG etc..

Gemäß Fig. 1a wird die vergrabene n⁺-dotierte Schicht 5 im p-Siliziumsubstrat 1 unter der n-dotierten Epitaxieschicht 10 durch Standardprozessschritte erzeugt, z.B. durch Implantation. Zusätzlich werden an ausgewählten Orten, z.B. punktförmig oder streifen- bzw. ringförmig die n⁺-Dotierungsbereiche 15 in die Epitaxieschicht 10 eingebracht, um n⁺-dotierte Verbindungen von der Oberfläche zur vergrabenen n⁺-Schicht 5 zu erzeugen. Optional können auf der Epitaxieschicht 1 eine Maskierungsschicht 20 oder mehrere solche Maskierungsschichten (z.B. aus Nitrid) abgeschieden und strukturiert werden.

Gemäß Fig. 1b können die n⁺-Dotierungsbereiche 15 durch elektrochemisches Ätzen in flusssäurehaltigen Medien ("Anodisieren") abhängig von den Anodisierbedingunen (Flusssäurekonzentration, Stromdichte, ...) in poröse n⁺-Bereiche ungewandelt oder gänzlich aufgelöst werden. Die Anodisiergeschwindigkeit hängt stark von der Dotierung des Siliziums ab. Niedrig dotiertes n-Silizium (n-Epitaxieschicht) wird nahezu nicht angegriffen, n⁺-dotiertes Silizium dagegen sehr gut. Diese Selektivität wird im Rahmen dieser Ausführungsform ausgenutzt.

In einem ersten, zeitgesteuerten Anodisierschritt werden die n⁺-dotierten Bereiche 15 in der Epitaxieschicht 1 mehr oder weniger vollständig porös geätzt. Die Porosität ist dabei bevorzugt größer als 50 %. Durch einen Wechsel der Anodisierbedingungen wird die vergrabene n⁺-dotierte Schicht 5 herausgelöst. Im Übergangsbereich vom n⁺-Bereich 5 zum p-dotierten Substrat 1 gibt es einen schwach n-dotierten Bereich, der als Anodisierbegrenzung wirkt. Durch die Form der vergrabenen n⁺-Dotierung 5 wird der herausgelöste Bereich definiert.

Gemäß Fig. 1c können nach Entfernen der Maske 20 in einem nachfolgenden Prozessschritt die porösen Bereiche 150 - falls gewünscht - sehr einfach geschlossen werden, da sie eine nahezu plane Oberfläche mit nur sehr kleinen Löchern aufweisen. Dies ist ein deutlicher Vorteil gegenüber standardmäßigen oberflächenmikromechanischen Herstellungsverfahren, bei denen meist Löcher mit Durchmessern von mehr als einem µm verschlossen werden müssen. Der Verschluss kann beispielsweise durch Abscheiden der Metallschicht 30 oder mehrerer Schichten (Oxid, Nitrid, Metall, BPSG, ...) oder durch Oxidation erfolgen. Der Prozessdruck beim Abscheiden definiert den Gasinnendruck in der Kaverne 50.

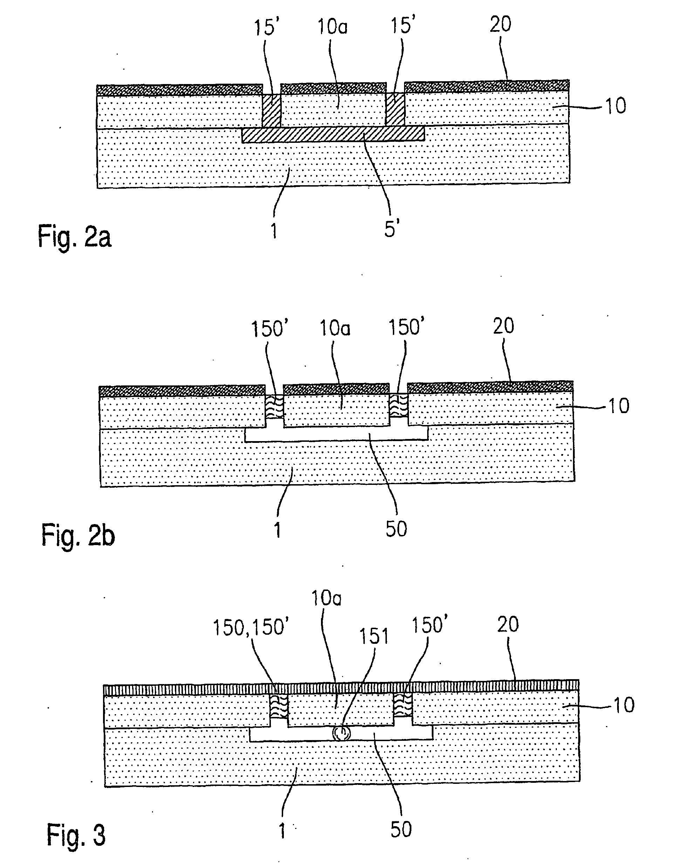

Fig. 2a,b zeigen eine schematische Querschnittsdarstellung des Herstellungsprozesses für ein mikromechanisches Bauelement gemäß einer zweiten Ausführungsform der vorliegenden Erfindung.Die verwendeten Dotierungen für die Atzbereiche sind hier variiert worden.

In Figur 2a, 2b zeigen zusätzlich zu den bereits eingeführten Bezugszeichen 5' eine vergrabene p⁺-dotierte Schicht und 15' p⁺-dotierte durchkontaktierte Bereiche.

In das.p-Substrat 1 wird bei diesem Beispiel eine p⁺⁻Dotierung eingebracht für die vergrabene Schicht 5' eingebracht. Darüber wird die n-Epitaxieschicht 10 aufgewachsen und mit den p⁺-Durchkontaktierungen 15' versehen.

Gemäß Fig. 2b wird der p⁺-dotierte Bereich 15' selektiv anodisiert, um den porösen p⁺-dotierten Bereich 150' zu bilden. Die n-Epitaxieschicht 10 wird dabei nicht angegriffen, und das p-Substrat 1 nur leicht, da die Anodisierrate von p⁺ deutlich höher ist als die von p und n.

Fig. 3 zeigt eine mögliche Komplikation bei der Herstellung des erfindungsgemäßen mikromechanischen Bauelements.

Beim Herauslösen der vergrabenen Dotierschicht besteht die Gefahr, dass an der Stelle, an der zwei Ätzfronten zusammentreffen, ein Siliziumsteg 151 zurückbleibt. Durch diesen Steg 151 würde die Membran 10a nicht vollständig freigestellt und somit ihre Funktion beeinträchtigt.

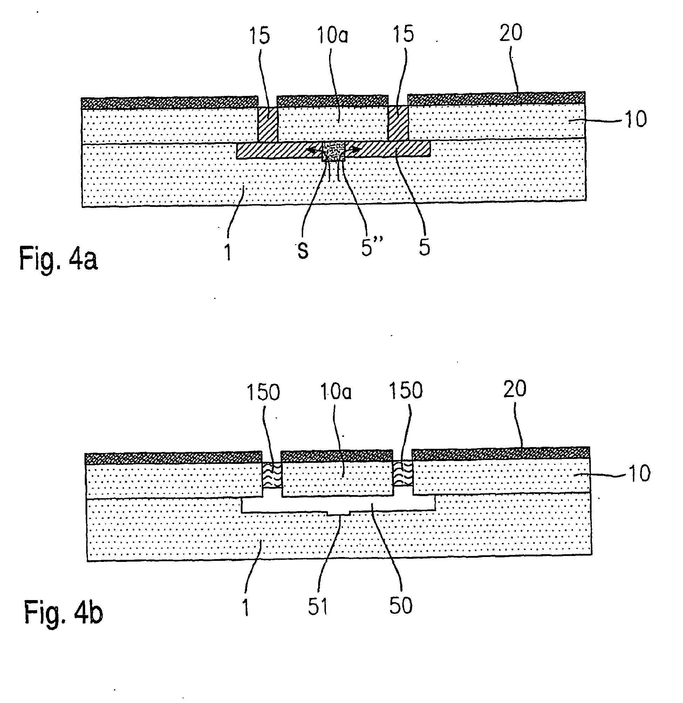

Fig. 4a,b zeigen eine schematische Querschnittsdarstellung des Herstellungsprozesses für ein mikromechanisches Bauelement gemäß einer dritten Ausführungsform der vorliegenden Erfindung.

Der im Zusammenhang mit Fig. 3 geschilderten Gefahr kann bei der ersten Ausführungsform dadurch begegnet werden, daß ein vergrabener p⁺-Dotierungsbereich 5" in der vergrabenen n⁺-Schicht 5 vorgesehen wird, wo die Ätzfronten bei der nachfolgenden Anodisierung die Ätzfronten aufeinandertreffen. Durch diesen p⁺-Dotierungsbereich 5' ' werden die Stromlinien S bei der Anodisierung gezielt geführt, so nach dem Herauslösen des Siliziums kein Steg zurückbleibt.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Die geschilderten und illustrierten Ausführungsformen stellen den Herstellungsablauf nur exemplarisch dar. Optional können neben der Membran oder in der Membran weitere Dotierungen realisiert werden, beispielsweise um Piezowiderstände in der Membran und eine Auswerteschaltung neben der Membran für einen integrierten Drucksensor herzustellen. Die vergrabene n⁺-dotierte Schicht und die n⁺-dotierten Zuführungen durch die Epitaxieschicht können so ausgestaltet werden, dass die vergrabene Schicht durch laterale n⁺⁻Ätzkanäle herausgelöst wird, die am Kanalende über die n⁺⁻Zuführungen mit der Oberfläche der Epitaxieschicht verbunden sind.

## Patentansprüche

1. Mikromechanisches Bauelement mit:
- einem Substrat (1) und
- einer oberhalb des Substrats (1) vorgesehenen einkristallinen Schicht (10), welche einen Membranbereich aufweist und
- einem unterhalb des Membranbereichs vorgesehenen Hohlraum (50) und
- einem oder mehreren innerhalb dem Membranbereichs der einkristallinen Schicht (10) vorgesehenen porösen Bereichen (150; 105') mit im Vergleich zur umgebenden Schicht (10) erhöhter Dotierung (n⁺; p⁺),
**dadurch gekennzeichnet, dass**
die einkristalline Schicht (10) eine Epitaxieschicht ist.

2. Mikromechanisches Bauelement nach Anspruch 1, **dadurch gekennzeichnet, dass** oberhalb der einkristallinen Schicht (10) eine oder mehrere Verschlussschichten (30) zum Verschließen der porösen Bereiche (150; 150') vorgesehen ist bzw. sind.

3. Mikromechanisches Bauelement nach Anspruch 1 oder 2, **dadurch gekennzeichnet, dass** die porösen Bereiche (150; 150') durch eine Oxidation verschlossen sind.

4. Mikromechanisches Bauelement nach Anspruch 1, 2 oder 3, **dadurch gekennzeichnet, dass** die einkristalline Schicht (10) und die porösen Bereiche (150) vom selben Dotierungstyp (n) sind.

5. Mikromechanisches Bauelement nach einem der vorhergehenden Ansprüche, **dadurch gekennzeichnet, dass** die einkristalline Schicht (10) und die porösen Bereiche (150) von verschiedenen Dotierungstypen (n; p) sind.

6. Verfahren zum Herstellen eines mikromechanischen Bauelement mit den Schritten
- Bereitstellen eines Substrats (1) und
- Vorsehen einer vergrabenen Schicht (5; 5') mit im Vergleich zum umgebenden Substrat (1) erhöhter Dotierung (n⁺; p⁺) an der Oberfläche des Substrats (1) und
- Vorsehen einer einkristallinen Schicht (10) oberhalb des Substrats (1) und
- Vorsehen von Bereichen (15; 15') mit erhöhter Dotierung (n⁺; p⁺) innerhalb der einkristallinen Schicht (10) und
- Selektives Porösätzen der Bereiche (15; 15') mit erhöhter Dotierung (n⁺; p⁺) zum Erzeugen entsprechender poröser Bereiche (150; 150') und
- Bilden eines Hohlraums (50) unter der einkristallinen Schicht (10) und eines darüber liegenden Membranbereichs (10a) durch Herauslösen der vergrabenen Schicht (5; 5') unter Verwendung der porösen Bereiche (159; 150') mittels eines Elektropolierprozesses
**dadurch gekennzeichnet, dass**
die einkristalline Schicht (10) durch Epitaxie vorgesehen wird.

7. Verfahren nach Anspruch 6, **dadurch gekennzeichnet, dass** oberhalb der einkristallinen Schicht (10) eine oder mehrere Verschlussschichten (30) zum Verschließen der porösen Bereiche (150; 150') vorgesehen wird bzw. werden.

8. Verfahren nach Anspruch 6 oder 7, **dadurch gekennzeichnet, dass** die porösen Bereiche (150; 150') durch eine Oxidation verschlossen werden.

9. Verfahren nach Anspruch 6, 7 oder 8, **dadurch gekennzeichnet, dass** die einkristalline Schicht (10) und die porösen Bereiche (150) vom selben Dotierungstyp (n) sind.

10. Verfahren nach einem der vorhergehenden Ansprüche 6 bis 9, **dadurch gekennzeichnet, dass** die einkristalline Schicht (10) und die porösen Bereiche (150) von verschiedenen Dotierungstypen (n: p) sind.

11. Verfahren nach einem der vorhergehenden Ansprüche 6 bis 10, wobei das Substrat (1) von einem ersten Leitungstyp (p) ist und die vergrabene Schicht (5) von einem zweiten Leitungstyp (n) ist, **dadurch gekennzeichnet, dass** in der vergrabenen Schicht (5) ein oder mehrere Bereiche (5") des ersten Leitungstyps (p) vorgesehen werden, die eine im Vergleich zum Substrat (1) erhöhte Dotierung (p⁺) aufweisen.

## Revendications

1. Composant micromécanique comprenant :
- un substrat (1) et
- une couche monocristalline (10) prévue au-dessus du substrat (1) et qui présente une zone membranaire et
- un espace creux (50) prévu en dessous de la zone membranaire et
- une ou plusieurs zones poreuses (150 ; 150') prévues à l'intérieur de la zone de membrane de la couche monocristalline (10), ayant un dopage accru (n⁺ ; p⁺) par rapport à la couche environnante (10),
**caractérisé en ce que**
la couche monocristalline (10) est une couche épitaxiale.

2. Composant micromécanique selon la revendication 1,
**caractérisé en ce qu'**
au-dessus de la couche monocristalline (10) est ou sont prévue(s) une ou plusieurs couche(s) de scellement (30) pour sceller les zones poreuses (150, 150').

3. Composant micromécanique selon la revendication 1 ou 2,
**caractérisé en ce que**
les zones poreuses (150 ; 150') sont scellées par oxydation.

4. Composant micromécanique selon la revendication 1, 2 ou 3,
**caractérisé en ce que**
la couche monocristalline (10) et les zones poreuses (150) sont du même type de dopage (n).

5. Composant micromécanique selon l'une des revendications précédentes,
**caractérisé en ce que**
la couche monocristalline (10) et les zones poreuses (150) sont de différents types de dopage (n ; p).

6. Procédé de fabrication d'un composant micromécanique, comprenant les étapes consistant à
- préparer un substrat (1) et
- prévoir une couche enfouie (5 ; 5') avec un dopage accru (n⁺ ; p⁺) par rapport au substrat environnant (1) sur la surface du substrat (1) et
- prévoir une couche monocristalline (10) au-dessus du substrat (1) et
- prévoir des zones (15 ; 15') ayant un dopage accru (n⁺; p⁺) à l'intérieur de la couche monocristalline (10) et
- graver des porosités de façon sélective dans les zones (15 ; 15') ayant un dopage accru (n⁺ ; p⁺) afin de générer des zones poreuses correspondantes (150 ; 150') et
- former un espace creux (50) sous la couche monocristalline (10) et une zone de membrane (10a) au-dessus de celui-ci par enlèvement de la couche enfouie (5 ; 5') en utilisant les zones poreuses (159 ;150'), au moyen d'un processus d'électropolissage,
**caractérisé en ce que**
la couche monocristalline (10) est prévue par épitaxie.

7. Procédé selon la revendication 6,
**caractérisé en ce qu'**
au-dessus de la couche monocristalline (10) est ou sont prévue(s) une ou plusieurs couche(s) de scellement (30) pour sceller les zones poreuses (150 ; 150').

8. Procédé selon la revendication 6 ou 7,
**caractérisé en ce que**
les zones poreuses (150; 150') sont scellées par oxydation.

9. Procédé selon la revendication 6, 7 ou 8
**caractérisé en ce que**
la couche monocristalline (10) et les zones poreuses (150) sont du même type de dopage (n).

10. Procédé selon l'une des revendications précédentes 6 à 9,
**caractérisé en ce que**
la couche monocristalline (10) et les zones poreuses (150) sont de différents types de dopages (n ; p).

11. Procédé selon l'une des revendications précédentes 6 à 10, le substrat (1) étant d'un premier type de conducteur (p) et la couche enfouie (5) étant d'un deuxième type de conducteur (n),
**caractérisé en ce que**
dans la couche enfouie (5) une ou plusieurs zone(s) (5") du premier type de conducteur (p), présentent un dopage accru (p⁺) par rapport au substrat (1).

## Claims

1. Micromechanical component, having
- a substrate (1), and
- a single-crystal layer (10) which is provided above the substrate (1) and has a membrane region, and
- a cavity (50) provided below the membrane region, and
- one or more porous regions (150; 105') which are provided within the membrane region of the single-crystal layer (10) and have an increased doping (n⁺; p⁺) compared to the surrounding layer (10),
**characterized in that**
the single-crystal layer (10) is an epitaxial layer.

2. Micromechanical component according to Claim 1, **characterized in that** one or more closure layers (30) for closing off the porous regions (150; 150') is/are provided above the single-crystal layer (10).

3. Micromechanical component according to Claim 1 or 2, **characterized in that** the porous regions (150; 150') are closed up by oxidation.

4. Micromechanical component according to Claim 1, 2 or 3, **characterized in that** the single-crystal layer (10) and the porous regions (150) are of the same doping type (n).

5. Micromechanical component according to one of the preceding claims, **characterized in that** the single-crystal layer (10) and the porous regions (150) are of different doping types (n; p).

6. Process for producing a micromechanical component, comprising the steps of
- providing a substrate (1), and
- providing a buried layer (5; 5') with an increased doping (n⁺; p⁺) compared to the surrounding substrate (1) at the surface of the substrate (1), and
- providing a single-crystal layer (10) above the substrate (1), and
- providing regions (15; 15') with an increased doping (n⁺; p⁺) within the single-crystal layer (10), and
- selectively porous-etching the regions (15; 15') with an increased doping (n⁺; p⁺) to produce correspondingly porous regions (150; 150'), and
- forming a cavity (50) below the single-crystal layer (10) and forming a membrane region (10a) above it by removing the buried layer (5; 5') using the porous regions (159; 150') by means of an electropolishing process,
**characterized in that**
the single-crystal layer (10) is provided by epitaxy.

7. Process according to Claim 6, **characterized in that** one or more closure layers (30) for closing off the porous regions (150; 150') is/are provided above the single-crystal layer (10).

8. Process according to Claim 6 or 7, **characterized in that** the porous regions (150; 150') are closed up by oxidation.

9. Process according to Claim 6, 7 or 8, **characterized in that** the single-crystal layer (10) and the porous regions (150) are of the same doping type (n).

10. Process according to one of the preceding Claims 6 to 9, **characterized in that** the single-crystal layer (10) and the porous regions (150) are of different doping types (n; p).

11. Process according to one of the preceding Claims 6 to 10, in which the substrate (1) is of a first conduction type (p) and the buried layer (5) is of a second conduction type (n), **characterized in that** one or more regions (5") of the first conduction type (p) which have an increased doping (p⁺) compared to the substrate (1) are provided in the buried layer (5).
